(19) Europäisches Patentamt

European Patent Office

Office européen des brevets

(11) **EP 1 020 028 B1**

(12) **EUROPEAN PATENT SPECIFICATION**

(45) Date of publication and mention
of the grant of the patent:
**09.07.2003 Bulletin 2003/28**

(21) Application number: **98943159.8**

(22) Date of filing: **07.09.1998**

(51) Int Cl.⁷: $H03H\ 21/00$

(86) International application number:
**PCT/SE98/01590**

(87) International publication number:
**WO 99/016170 (01.04.1999 Gazette 1999/13)**

(54) **DEVICE FOR SEPARATION OF SIGNALS**

VORRICHTUNG ZUR TRENNUNG VON SIGNALEN

DISPOSITIF DE SEPARATION DE SIGNAUX

(84) Designated Contracting States:
**AT BE CH CY DE DK ES FI FR GB GR IE IT LI LU MC NL PT SE**

(30) Priority: **05.09.1997 SE 9703212**

(43) Date of publication of application:
**19.07.2000 Bulletin 2000/29**

(73) Proprietor: **Telefonaktiebolaget L M Ericsson (Publ)**
**126 25 Stockholm (SE)**

(72) Inventors:
• **Lindgren, Ulf**
  **226 49 Lund (SE)**
• **Broman, Holger**
  **434 46 Kungsbacka (SE)**
• **Sahlin, Henrik**
  **652 27 Karlstad (SE)**

(74) Representative: **Hammond, Andrew David et al**
**Ström & Gulliksson IP AB**
**Sjöporten 4**
**417 64 Göteborg (SE)**

(56) References cited:
• **ADAPTIVE SYSTEMS IN CONTROL AND SIGNAL PROCESSING 1992, Volume 1-3, July 1992, LJUNG L. et al., "A Comment on Leakage in Adaptive Algorithms", pages 139-143.**

## Description

Technical field

Background of invention

Algorithms for signal separation are well known. Many of the described methods deal with mixtures without memories (so called 'instantaneous mixtures'). These are mixtures with constants, i.e. without delays. The signals are assumed to be mixed without having been delayed in time between the sensors.

A scenario more appropriate for regularising in the criterion is for mixtures with delays (so called 'dynamic mixtures'). One of the first methods for attacking this problem was presented by Widrow et al ("Adaptive noise cancelling: Principles and applications", IEEE Proceedings, December 1975). This method is based on two measurable signals, of which one only contains the disturbance and no contribution from the desired signal. According to the present invention both disturbances and the desired signal can be present in all measurable signals. This problem is unavoidable when the sensors are located near to each other, for instance in a cellular phone or a hearing aid.

An often used criterion is based on a contrast function suggested by Comon ("Independent component analysis, a new concept?", Signal Processing, 1994). A contrast function must be scaling invariant and assume its maximum value for statistically independent signals. A variety of different contrast functions has been suggested.

Criteria which are based on cross correlations between out signals from the separation structure have been suggested. Lindgren et al have described a criterion for two observable signals (Lindgren, Broman, "Source separation: Using a criterion based on second order statistics", Technical Report CTH-TE-36, Chalmers, Sweden, 1996, forthcoming in IEEE Trans. on Signal

$$V \;=\; \sum_{m=-L}^{L} (R_{s1s2}(m))^2$$

where L is a positive integer and $R_{s1s2}(m)$ denotes the cross correlation between $s_1$ and $s_2$ for a delay of one of the signals with m samples. This criterion describes how much the signals $s_1$ and $s_2$ are correlated for delays between -L and L.

The signals that you want to separate do not have to be acoustic. Sahlin describes (Sahlin and Broman, "Blind separation of images", Proceedings of 30th Asilomar Conference on Signals, Systems and Computers, 1996) how signal separation can be applied on images (two dimensional signals).

Regularising can be found at system identification. The method is then used e.g. to avoid problem with inverting poorly conditioned matrices (e.g. Ljung, "System Identification, Theory for the user, Prentice-Hall, Englewood Cliffs, NJ, 1987) or to reduce the variance of parameter estimates to a cost of increased systematic error (Ljung, Sjöberg, "A comment on 'leakage' in adaptive algorithms", Technical Report LiTH-I-ISY-1304, Linköping University, Sweden, 1992). The choice of the magnitude of δ has been dealt with in the latter reference in the case of linear regression models and a criterion based on the square of the prediction error.

The document "A comment on 'Leakage' in Adaptive Algorithms", from Adaptive Systems in Control and Signal Processing 1992, Volume 1-3, July, 1992, pp 139-143, by Ljung, L. and Sjöberg, J. deals with the problem of adaptive control and adaptive signal processing. In this document a linear regression model, $y(t)=\phi^T(t)\theta$, is used to estimate filter parameters, $\theta(t)$,

$$\theta(t) = \theta(t-1)+\mu_t P_t \phi(t)(y(t)-\phi^T(t))\theta(t-1)$$

where $\theta(t)$ is the estimate at time t and $\mu_t$ is a step size. By choosing $P_t=R^{-1}(t)$, where R(t) is a weighted and normalized estimate of the covariance matrix of the regressors, then the estimate for $\theta(t)$ becomes the Recursive Least Squares (RLS) algorithm that minimizes a weighted least squares criterion. A criterion is a mathematical expression which adopts a minimum for the specific values of the filter parameters, $\theta$. Choosing $P_t=I$ gives the Least Mean Squares (LMS) algorithm instead. Further in this document, a "pull" term, or a 'leakage' term, is included in the expression for $\theta(t)$. This is one way of making it possible to draw $\theta$ to a certain parameter value. Thus, 'leakage' is a way to draw filter parameters, $\theta$, to specific values in a criterion. Also, this document states that another name for performing 'leakage' operations is regularising. The 'leakage' presented in this document is based on introducing a 'leakage' term in the expression for $\theta(t)$ above and only there. This document does not deal with introducing the regularising term in the criterion itself.

The European patent application No. 565 479 discloses a method based on the cross poly spectrum. The procedure according to this patent application is based on higher order statistics (HOS). It is publicly known that methods based on higher order statistics require a large number of samples in order to achieve good estimates. This results in that algorithms based on HOS converge slowly and performs worse compared to methods based on second order statistics.

The patent US-4, 208, 786 discloses a signal separation algorithm based on second order statistics, but which does not work in a general case. The suggested algorithm only works if both channel filters have the same value of the direct term, i.e. $a_0 = b_0$ with references

according to equation (14) and (15) in the description. That the method does not work for different direct terms is clear from equations (49) and (50). These equations describe how coefficients are estimated. The updating equations for the filter coefficients are the following when only dealing with the direct terms.

$$A_0(n) = a_0(n-1) + Y_1 V_2(n) V_1(n)$$

and

$$B_0(n) = b_0(n-1) + Y_2 V_1(n) V_2(n).$$

It is clear that the updating terms for the direct terms are identical. Also, others have presented similar algorithms but under the assumption that both direct terms are zero (Van Gerven, Van Compernolle; "Signal separation by symmetric adaptive decorrelation: Stability, Convergence and Uniqueness", IEEE Trans. Signal Processing, July, 1995).

The invention

The invention relates to a class of methods for separating two or more signals which are mixed in an unknown way by signal separation. The present invention relates to a way of improving the performance of the methods by means of regularising of the criterion. Regularising means that the parameters are 'drawn' to specific values. Thereby, regularising decreases the problem which may occur due to over parameterisation.

Short description of the drawings

In the following preferred embodiments of the invention will be described giving reference to the appended drawings, in which:

Figure 1 shows a cellular phone with the invention implemented therein;
Figure 2 shows a scheme according to the invention;
Figure 3a-3f shows graphs of systematic error, standard deviation och means square error.
Figure 4 shows the increase of SNB as a function of the regularising according to the present invention.

Detailed description of preferred embodiments

Signal separation can be applied when you want to separate a number of signals from each other. The method is based on access to at least as many different mixtures as you want to separate. For instance, the invention can be used if two persons are talking to each other at the same time in a room, and you are having problem hearing what one of the persons is saying due to the other voice. Signal separation is based on signals from e.g. two microphones to determine filters in a separation structure and therefrom filter out each voice.

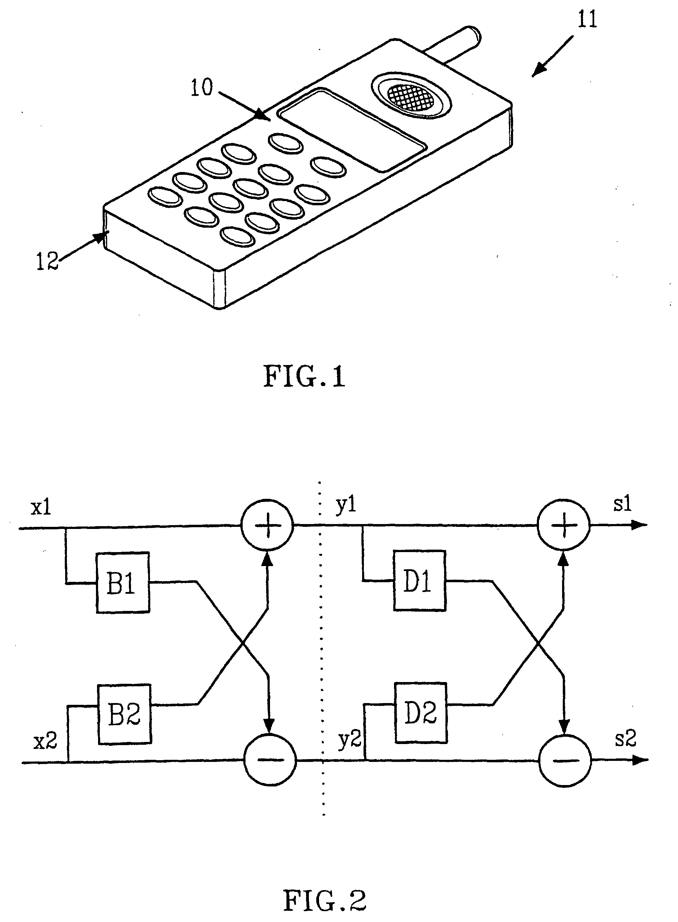

The method is based on modelling the mixture by means of filters comprising delays. Figure 2a shows an example where a model of a mixture of two signals is presented. Here $x_1$ and $x_2$ denote the desired but unknown and unmeasurable signals. The only signals which are measurable are $y_1$ and $y_2$. $y_1$ is modelled as $x_1$ plus a filtered version of $x_2$, i.e.

$$Y_1 = X_1 + B_2 X_2$$

In the same way the following is modelled

$$Y_2 = X_2 + B_1 X_1$$

The model of the mixture includes the filters $B_1$ and $B_2$. The signals $Y_1$ and $Y_2$ are measurable and based on them a filter in a separation structure will be estimated. The output signals from the separation structure is

$$S_1 = Y_1 - D_2 Y_2 = (1 - D_2 B_1) X_1 + (B_2 - D_2) X_2$$

and

$$S_2 = Y_2 - D_1 Y_1 = (1 - D_1 B_2) x_2 + (B_1 - D_1) X_1$$

According to the above it is clear if $B_1 = D_1$ and $B_2 = D_2$ the signals are being separated, i.e. the out signals $S_1$ and $S_2$ are only dependent on $X_1$ and $X_2$, respectively. A common way of performing the determination of the estimates of the filters in the separation structure is to search for the filter parameters which give minimum or maximum value of a criterion V. A plurality of different criteria nave been suggested, e.g. based on cross correlations, contrast functions and cross poly spectrum, as described above.

Performance of signal separation can be defined in many ways. Mean square deviation between estimated and true parameters is one of these measures. A measure closer to application is how well the method can suppress interfering signals, i.e. the signal to noise ratio, SNR). Above all the measured value of the increase of SNR between measured signals and separated signals is of interest.

The effect of regularising

Estimates of the channel is by nature afflicted with deviations from the truth. A measure of the mean deviation from the true value is the "systematic error". The systematic error for a parameter is the average of the deviations of the estimated parameter from the truth. "The variance" of the parameter estimates is a measure of variations of the mean deviation from the mean value of the estimate, i.e. how much the parameter estimate varies between each estimate. The variance is the mean value of the difference between estimate and squared mean value. "Standard deviation" is the square root of the variance. Finally the "mean square deviation" is the mean value of the difference between estimate and true value of the square of the parameter.

Regularising can be introduced in the signal separation algorithm as a means to reduce the variance of the parameters to be estimated. These parameters are usually the coefficients of the filters in a separation structure. Another name for regularising is leakage. The need arises primarily when the problem is heavily over parameterised. This can occur when only a few filter parameters not will be zero, but you do not know which ones. A method to solve this problem is to try to estimate by means of some method what parameters are necessary, and then only determine the values of these. If the system varies with time also this model structure must be varying with time. An alternative way of performing this method of obtaining model estimates is to introduce regularising.

Regularising is now introduced as a modified criterion, V' :

$$V' = V + \delta|\theta\text{-}\theta^{\#}|$$

Here V denotes the criterion to be minimised in order to estimate the parameters of a separation structure, $\delta$ is a design variable determining the degree of which the criterion should be regularissd, $\theta$ is a column vector comprising the parameters to be estimated and $\theta^{\#}$ is a column vector with possible knowledge of the real parameters. The regularising is thus introduced by adding a so called regularising term to the original criterion.

A more general formulation is

$$V' = v + (\theta\text{-}\theta^{\#})C(\theta\text{-}\theta^{\#})^{H},$$

where C is a weight matrix and H denotes the Hermitian operator (conjugating and transposing operator). This latter formulation gives e.g. a possibility to a varying regularising of the parameters.

Thus, a possibility which is given when using regularising in the algorithm is to control the parameters towards specific values by a suitable choice of $\theta^{\#}$. These specific of the parameters can be obtained from physical modelling (e.g sound propagation in a room) or measurements under controlled circumstances. In the case of over parameterisation it is possible to choose $\theta^{\#}$ to a

vector of zeros, which means that all parameters are drawn towards zero.

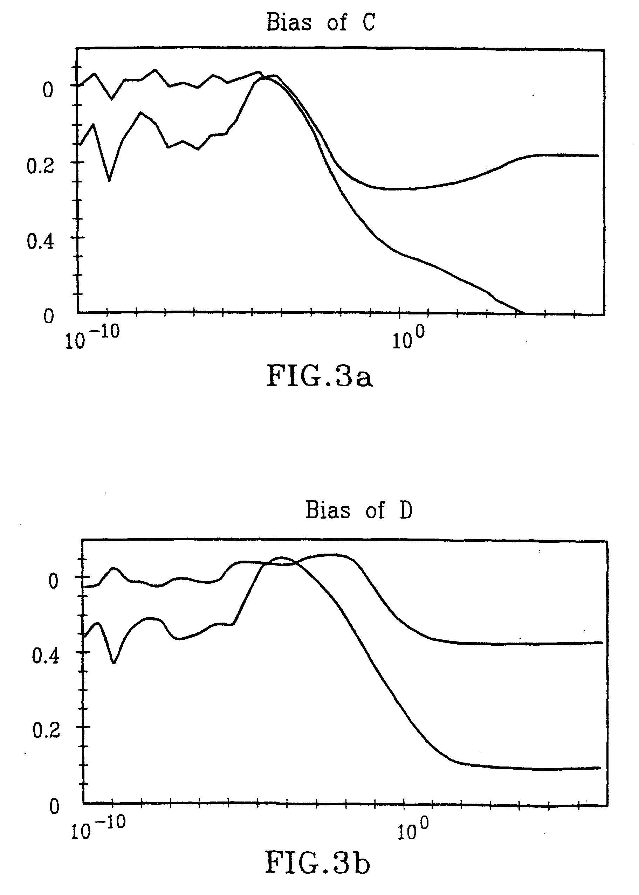

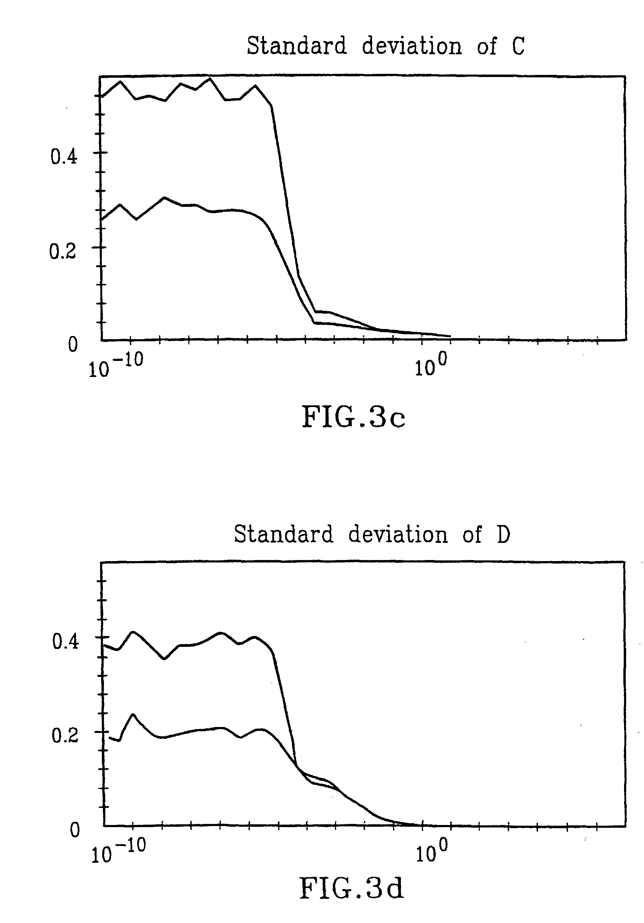

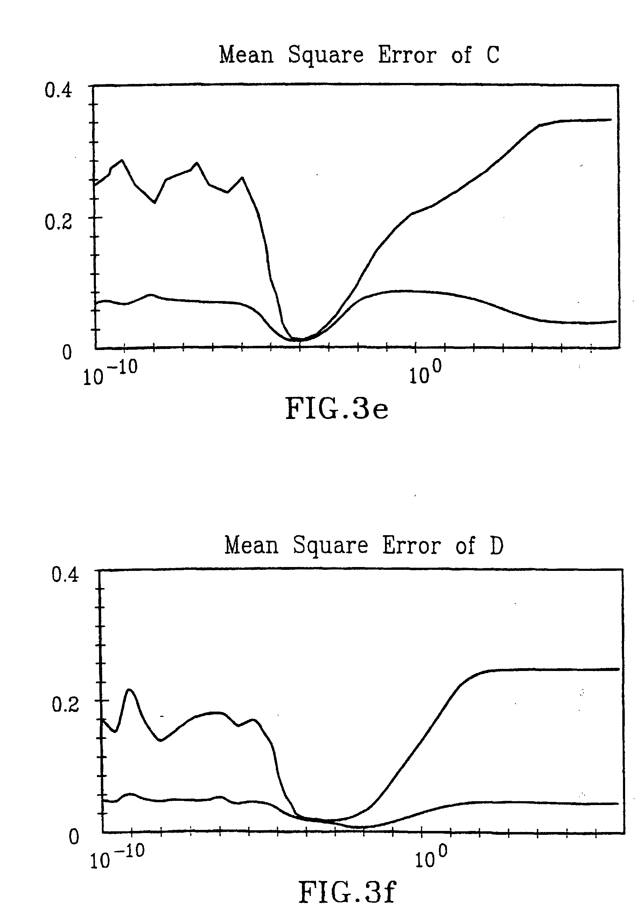

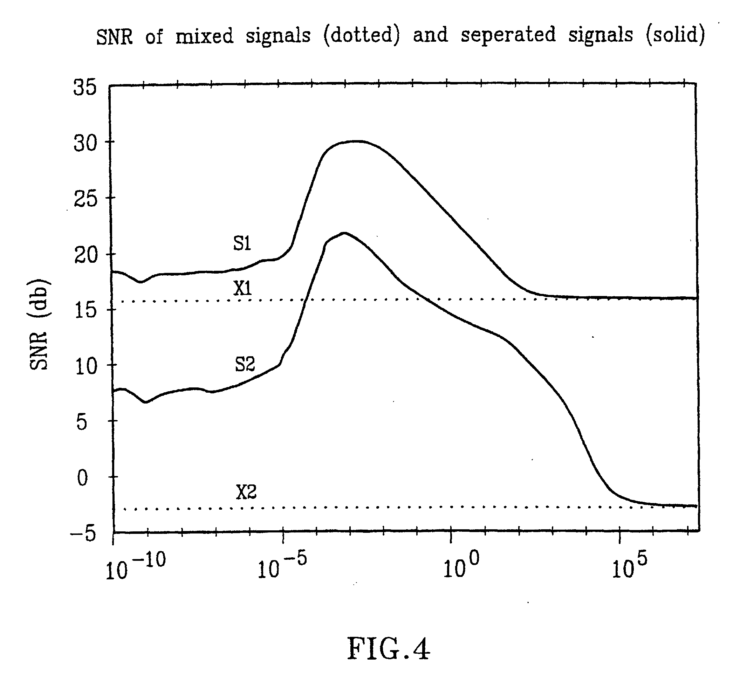

An illustration is shown in figure 3. There it can be seen how systematic error, standard deviation and mean square error vary with different values of the regularising parameter 5. In the figure it can be seen how mean square error is greatly reduced in an interval of $\delta$ and then it increases outside the interval. In figure 4 the result of the method is presented as the quality improvement of one of the signals expressed as signal to noise ratio (SNR). A great increase in SNR for $s_1$ is presented in an interval compared to a non regularised criterion (small $\delta$ values). The signals used in figures 1 and 2 are computer generated sequences.

Regularising decreases the variance of the parameters on behalf of an increased systematic error. The parameter $\delta$ should thus be selected so that the gain accomplished in the performance of the method due to decreased variance does not exceed the loss in performance due to increased systematic error. Ideally $\delta$ should be chosen so that these two effects balance each other in the point which results in a maximisation of the performance of the algorithm.

An application is signals from microphones which are located at an approximate distance of 10 cm from each other. Figure 1 shows application of the method according to the invention in a cell phone 10 provided with two microphones, 11 and 12 as the first and second signal sources. The transport of sound in the room can be described with a few parameters but knowledge of which ones these are is not normally at hand. In order not to introduce limitations of from where the signals come filters with up to 20 coefficients each are required. The introduction of regularising in the criterion results in that the algorithm becomes practically applicable.

In the following a synopsis of some possible fields of application for signal separation using regularising is presented. Use of the method is when there are two or more signals which are mixed in an unknown way och there is a desire to filter out one or more of these. The method requires as many sensors as (or differently put, as many different versions of the mixes) as the number of signals to be filtered out. The strength of introducing regularising is that the sensitivity for over parameterisation decreases.

Signal separation with regularising is well suited for noise suppression in telephony. A receiver of the signals without any noise reducing method will perceive noise and other disturbances in the surroundings to the speaker as very disturbing. This is especially the case with cellular phones which are used in the most varying surroundings. Also the coding methods for the cellular phones of today adapted for human speech why acoustic disturbances can be even more disturbing for the receiver. Therefore it is important to achieve a higher signal quality before the transmission to the receiver. A requirement for the method to work is that the phone comprises at least two microphones. These are to be mounted at such a distance from each other so that the signals from them are essentially different. At the same time a long distance between the microphones creates the need of a filter with many coefficients in the modelling of the channel between the microphones. This strengthens the need of regularising when the introduction allows introduction of many filter coefficients without any greater decrease in performance.

People with hearing aids often have the problem that all sounds in the surroundings are equally amplified. Several persons talking simultaneously, music, machines etc creates surroundings where the person with a hearing aid cannot have a normal conversation due to the limited perception of others speaking. By mounting more than one microphone on the hearing aid and introducing a signal separation algorithm med regularising the level of perception can be greatly increased.

Signal separation is to filter ECG (Electrocardiogram) of fetus as described in an article by Zarzoso et al (Bacharis, A.K. Nandi and V. Zarzoso, "Foetal ECG Extraction using Blind Source Separation Methods", Proceedings of EUSIPCO '96). When measuring ECG of fetus also the mother's ECG is included. There is a desire to diminish this by means of filtering by using several sensors and a signal separation algorithm. Zarzoso only used channel models without delays which is considered insufficient at a high sampling rate and with sensors well distributed on the mother. Also methods based on higher order statics were often used which as opposed to methods based on higher order statistics requires a great number of samples (long measuring time) in order to work well. The introduction of the regularised criterion probably improves performance and also gives a more robust algorithm. Signal separation with regularising can also be used within fields close at hand such as EEG (Electroence-phalogram) and ENG (Electroneurogram).

In an article by Sahlin (H. Sahlin and H. Broman, "Blind Separation of Images", Proceedings of 30th Asilomar Conference on Signals, Systems, and Computers) use of signal separation in image processing is suggested. The method is based on a criterion of squared cross correlations and access to more than one image of mixtures. The method is suggested to be used in e.g. medical image processing (X ray, ultra sound, magnetic resonance, etc.) where representations of inner organs and the like often are disturbed by over- and underlying structures. The signal separation algorithm would then estimate the differences between the registered images and use this information to generate clearer images of desired structures. The differences between the registered images can e.g. be the sharpness at different levels, the natural movements of the organs or a minor movement of the camera. In the two latter cases the introduction of regularising would probably imply a great improvement in performance when movement can be modelled by a filter a few coefficients not being zero but with a great number of coefficient with zero value. When modelling of these filters there is normally no knowledge available of which coefficients to be estimated and which are zero which results in a heavily over parameterised problem. The introduction of a regularised criterion would result in a better result.

Other possible application are hydro phone technology, measurement of vibration, radio communication with broad band signals, or when ever there is access to two or more measurements of unknown mixtures of signals.

The invention is not limited to the described preferred embodiments. Variations and modifications within the scope of the appended patent claims can naturally be found.

**Claims**

1. In a device for estimating filter parameters for separating at least two signals ($S_1$, $S_2$) from each of a number of mixtures of signals, where the number of different mixtures ($X_1$, $X_2$) is at least as great as the number of signals to be separated, a modified criterion (V') based on a criterion (V), that is minimised for the estimated filter parameters in a separation structure, and a regularising amendment (($\theta$-$\theta^\#$)C($\theta$-$\theta^\#$)$^H$),
   **characterised in,**
   **that** the regularising amendment is arranged to comprise a first vector ($\theta$) with the filter parameters to be estimated, a second vector ($\theta^\#$) with information of filter parameters based on physical modelling and a filter parameter weight matrix (C), and a product of a difference between said first ($\theta$)and second vector ($\theta^\#$), the filter parameter weight matrix (C) and a conjugated and transposed difference (C($\theta$-$\theta^\#$)$^H$) between said first and second vector.

2. In a device for estimating filter parameters for separating at least two signals ($S_1$, $S_2$) from each of a number of mixtures of signals, where the number of different mixtures ($X_1$, $X_2$) is at least as great as the number of signals to be separated, a modified criterion (V') based on a criterion (V), that is minimised for the estimated filter parameters in a separation structure, and a regularising amendment ($\delta|\theta$-$\theta^\#|$)
   **characterised in,**
   **that** the regularising amendment is arranged to comprise a first vector ($\theta$) with the filter parameters to be estimated, a second vector ($\theta^\#$) with information of filter parameters based on physical modelling and a design variable ($\delta$), and a product of the design variable and a modulus of a difference between said first and second vector.

3. In a communication device comprising at least two microphones (11, 12), which device is arranged for separating at least two signals ($S_1$, $S_2$) from each of a number of mixtures of signals, where the number of different mixtures ($X_1$, $X_2$) is at least as great as the number of signals to be separated, a modified criterion (V') based on a criterion (V), that is minimised for the estimated filter parameters in a separation structure and a regularising amendment $((\theta-\theta^{\#})C(\theta-\theta^{\#})^H)$,

**characterised in,**

**that** the regularising amendment is arranged to comprise a first vector ($\theta$) with the filter parameters to be estimated, a second vector ($\theta^{\#}$) with information of filter parameters based on physical modelling and a filter parameter weight matrix (C), and a product of a difference between said first ($\theta$) and second vector ($\theta^{\#}$), the filter parameter weight matrix (C) and a conjugated and transposed difference $(C(\theta-\theta^{\#})^H)$ between said first and second vector.

**4.** Device according claim 3,
**characterised in,**
**that** it is a telephone (10) or a hearing aid.

**5.** In a device comprising at least two sensors for medical diagnosing, such as ECG, which device is arranged for separating at least two signals ($S_1$, $S_2$) from each of a number of mixtures of signals, in which device the number of mixtures ($X_1$, $X_2$) is at least as great as the number of signals to be separated, the device being arranged to comprise a modified criterion (V') based on a criterion (V), that is minimised for the estimated filter parameters in a separation structure and a regularising amendment $((\theta-\theta^{\#})C(\theta-\theta^{\#})^H)$,

**characterised in,**

**that** the regularising amendment is arranged to comprise a first vector ($\theta$) with the filter parameters to be estimated, a second vector ($\theta^{\#}$) with information of filter parameters based on physical modelling and a filter parameter weight matrix (C), and a product of a difference between said first ($\theta$) and second vector ($\theta^{\#}$), the filter parameter weight matrix (C) and a conjugated and transposed difference $(C(\theta-\theta^{\#})^H)$ between said first and second vector.

**6.** In a device for image processing for providing clearer images of desired structures, which device is arranged for separating at least two signals ($S_1$, $S_2$) from each of a number of mixtures of signals, where the number of mixtures ($X_1$, $X_2$) is at least as great as the number of signals to be separated, the device being arranged to comprise a modified criterion (V') based on a criterion (V), that is minimised for the estimated filter parameters in a separation structure and a regularising amendment $((\theta-\theta^{\#})C(\theta-\theta^{\#})^H)$,

**characterised in,**

**that** the regularising amendment is arranged to comprise a first vector ($\theta$) with the filter parameters to be estimated, a second vector ($\theta^{\#}$) with information of filter parameters based on physical modelling and a filter parameter weight matrix (C), and a product of a difference between said first ($\theta$) and second vector ($\theta^{\#}$), the filter parameter weight matrix (C) and a conjugated and transposed difference $(C(\theta-\theta^{\#})^H)$ between said first and second vector.

**Patentansprüche**

**1.** In einer Einrichtung zum Abschätzen von Filterparametern zum Trennen von mindestens zwei Signalen ($S_1$, $S_2$) von jeder einer Anzahl von Signalmischungen, wobei die Anzahl von unterschiedlichen Mischungen ($X_1$, $X_2$) mindestens so groß ist wie die Anzahl von zu trennenden Signalen, ein modifiziertes Kriterium (V') basierend auf einem Kriterium (V), welches minimiert ist für die abgeschätzten Filterparameter in einer Trennungsanordnung, und einer Regularisierungsänderung $((\theta-\theta^{\#})C(\theta-\theta^{\#})^H)$,

**dadurch gekennzeichnet, dass**

die Regularisierungsänderung so angeordnet ist, dass sie einen ersten Vektor ($\theta$) mit den abzuschätzenden Filterparametern, einen zweiten Vektor ($\theta^{\#}$) mit Information von Filterparametern, basierend auf physikalischer Modellierung und einer Filterparameter-Gewichtungsmatrix (C), und ein Produkt aus einer Differenz zwischen dem ersten ($\theta$) und zweiten ($\theta^{\#}$) Vektor, der Filterparameter-Gewichtungsmatrix (C) und einer konjugierten und transponierten Differenz $(C(\theta-\theta^{\#})^H)$ zwischen dem ersten und zweiten Vektor umfasst.

**2.** In einer Einrichtung zum Abschätzen von Filterparametern zum Trennen von mindestens zwei Signalen ($S_1$, $S_2$) von jeder einer Anzahl von Signalmischungen, wobei die Anzahl von unterschiedlichen Mischungen ($X_1$, $X_2$) mindestens so groß ist wie die Anzahl von zu trennenden Signalen, ein modifiziertes Kriterium (V') basierend auf einem Kriterium (V), welches minimiert ist für die abgeschätzten Filterparameter in einer Trennungsanordnung, und einer Regularisierungsänderung $(\delta|\theta-\theta^{\#}|)$,

**dadurch gekennzeichnet, dass**

die Regularisierungsänderung so angeordnet ist, dass sie einen ersten Vektor ($\theta$) mit den abzuschätzenden Filterparametern, einen zweiten Vektor ($\theta^{\#}$) mit Information von Filterparametern, basierend auf physikalischer Modellierung und einer Entwurfsvariable ($\delta$), und ein Produkt aus der Entwurfsvariablen und einem Betrag aus einer Differenz zwischen dem ersten und zweiten Vektor umfasst.

**3.** In einer Kommunikationseinrichtung, welche mindestens zwei Mikrofone (11, 12) umfasst, wobei die Einrichtung so angeordnet ist, dass sie mindestens zwei Signale ($S_1$, $S_2$) von jeder einer Anzahl von Signalmischungen trennt, wobei die Anzahl von unterschiedlichen Mischungen ($X_1$, $X_2$) mindestens so groß ist wie die Anzahl von zu trennenden Signalen, ein modifiziertes Kriterium (V') basierend auf einem Kriterium (V), welches minimiert ist für die abgeschätzten Filterparameter in einer Trennungsanordnung, und einer Regularisierungsänderung (($\theta$-$\theta^{\#}$)C($\theta$-$\theta^{\#}$)$^H$),

**dadurch gekennzeichnet, dass**

die Regularisierungsänderung so angeordnet ist, dass sie einen ersten Vektor ($\theta$) mit den abzuschätzenden Filterparametern, einen zweiten Vektor ($\theta^{\#}$) mit Information von Filterparametern, basierend auf physikalischer Modellierung und einer Filterparameter-Gewichtungsmatrix (C), und ein Produkt aus einer Differenz zwischen dem ersten ($\theta$) und zweiten ($\theta^{\#}$) Vektor, der Filterparameter-Gewichtungsmatrix (C) und einer konjugierten und transponierten Differenz (C($\theta$-$\theta^{\#}$)$^H$) zwischen dem ersten und zweiten Vektor umfasst.

4. Einrichtung nach Anspruch 3,
   **dadurch gekennzeichnet, dass**
   sie ein Telefon (10) oder eine Hörhilfe ist.

5. In einer Einrichtung, welche mindestens zwei Sensoren zur medizinischen Diagnose umfasst, beispielsweise ECG, wobei die Einrichtung angeordnet ist zum Trennen von mindestens zwei Signalen ($S_1$, $S_2$) von jeweils einer Anzahl von Signalmischungen, wobei in der Einrichtung die Anzahl von Mischungen ($X_1$, $X_2$) mindestens so groß ist wie die Anzahl von zu trennenden Signalen, ist die Einrichtung so angeordnet, dass sie ein modifiziertes Kriterium (V') umfasst, basierend auf einem Kriterium (V), welches minimiert ist für die abgeschätzten Filterparameter in einer Trennungsanordnung und einer Regularisierungsänderung (($\theta$-$\theta^{\#}$)C($\theta$-$\theta^{\#}$)$^H$),
   **dadurch gekennzeichnet, dass**
   die Regularisierungsänderung so angeordnet ist, dass sie einen ersten Vektor ($\theta$) mit den abzuschätzenden Filterparametern, einen zweiten Vektor ($\theta^{\#}$) mit Information von Filterparametern, basierend auf physikalischer Modellierung und einer Filterparameter-Gewichtungsmatrix (C), und ein Produkt aus einer Differenz zwischen dem ersten ($\theta$) und zweiten ($\theta^{\#}$) Vektor, der Filterparameter-Gewichtungsmatrix (C) und einer konjugierten und transponierten Differenz (C($\theta$-$\theta^{\#}$)$^H$) zwischen dem ersten und zweiten Vektor umfasst.

6. In einer Einrichtung zur Bildverarbeitung, zur Bereitstellung deutlicherer Bilder von gewünschten Anordnungen, wobei die Einrichtung zum Trennen von mindestens zwei Signalen ($S_1$, $S_2$) von jeweils einer Anzahl von Signalmischungen angeordnet ist, wobei die Anzahl von Mischungen ($X_1$, $X_2$) mindestens so groß ist wie die Anzahl von zu trennenden Signalen, ist die Einrichtung so angeordnet, dass sie ein modifiziertes Kriterium (V') umfasst, basierend auf einem Kriterium (V), welches minimiert ist für die abgeschätzten Filterparameter in einer Trennungsanordnung und einer Regularisierungsänderung (($\theta$-$\theta^{\#}$)C($\theta$-$\theta^{\#}$)$^H$),

**dadurch gekennzeichnet, dass**

die Regularisierungsänderung so angeordnet ist, dass sie einen ersten Vektor ($\theta$) mit den abzuschätzenden Filterparametern, einen zweiten Vektor ($\theta^{\#}$) mit Information von Filterparametern, basierend auf physikalischer Modellierung und einer Filterparameter-Gewichtungsmatrix (C), und ein Produkt aus einer Differenz zwischen dem ersten ($\theta$) und zweiten ($\theta^{\#}$) Vektor, der Filterparameter-Gewichtungsmatrix (C) und einer konjugierten und transponierten Differenz (C($\theta$-$\theta^{\#}$)$^H$) zwischen dem ersten und zweiten Vektor umfasst.

**Revendications**

1. Dans un dispositif pour estimer des paramètres de filtre pour séparer au moins deux signaux ($S_1$, $S_2$) de chacun d'un certain nombre de mélanges de signaux, où le nombre de mélanges différents ($X_1$, $X_2$) est au moins aussi grand que le nombre de signaux devant être séparés, un critère modifié (V') basé sur un critère (V), qui est minimisé pour les paramètres de filtre estimés dans une structure de séparation, et une modification de régularisation (($\theta$-$\theta^{\#}$)C($\theta$-$\theta^{\#}$)$^H$),
   **caractérisé en ce que**
   la modification de régularisation est agencée de façon à comporter un premier vecteur ($\theta$) avec les paramètres de filtre devant être estimés, un second vecteur ($\theta^{\#}$) avec une information de paramètres de filtre basée sur une modélisation physique et une matrice (C) de pondération de paramètres de filtre et un produit d'une différence entre lesdits premier ($\theta$) et second ($\theta^{\#}$) vecteurs, la matrice (C) de pondération de paramètres de filtre et une différence conjuguée et transposée (C($\theta$-$\theta^{\#}$)$^H$) entre lesdits premier et second vecteurs.

2. Dans un dispositif pour estimer des paramètres de filtre pour séparer au moins deux signaux ($S_1$, $S_2$) de chacun d'un certain nombre de mélanges de signaux, où le nombre de mélanges différents ($X_1$, $X_2$) est au moins aussi grand que le nombre de signaux devant être séparés, un critère modifié (V') basé sur un critère (V), qui est minimisé pour les paramètres de filtre estimés dans une structure de séparation, et une modification de régularisation ($\delta|\theta$-$\theta^{\#}|$)
   **caractérisé en ce que**
   la modification de régularisation est agencée de façon à comporter un premier vecteur ($\theta$) avec les pa-

ramètres de filtre devant être estimés, un second vecteur ($\theta^{\#}$) avec une information de paramètres de filtre basée sur une modélisation physique et une variable nominale ($\delta$), et un produit de la variable nominale et d'un module d'une différence entre lesdits premier et second vecteurs.

3. Dans un dispositif de communication comportant au moins deux microphones (11, 12), lequel dispositif est agencé pour séparer au moins deux signaux ($S_1$, $S_2$) de chacun d'un certain nombre de mélanges de signaux, où le nombre de mélanges différents ($X_1$, $X_2$) est au moins aussi grand que le nombre de signaux devant être séparés, un critère modifié (V') basé sur un critère (V), qui est minimisé pour les paramètres de filtre estimés dans une structure de séparation, et une modification de régularisation (($\theta-\theta^{\#}$)$C(\theta-\theta^{\#})^H$),
   **caractérisé en ce que**
   la modification de régularisation est agencée de façon à comporter un premier vecteur ($\theta$) avec les paramètres de filtre devant être estimés, un second vecteur ($\theta^{\#}$) avec une information de paramètres de filtre basée sur une modélisation physique et une matrice (C) de pondération de paramètres de filtre, et un produit d'une différence entre lesdits premier ($\theta$) et second ($\theta^{\#}$) vecteurs, la matrice (C) de pondération de paramètres de filtre et une différence conjuguée et transposée ($C(\theta-\theta^{\#})^H$) entre lesdits premier et second vecteurs.

4. Dispositif selon la revendication 3,
   **caractérisé en ce**
   **qu'**il s'agit d'un téléphone (10) ou d'une prothèse auditive.

5. Dans un dispositif comportant au moins deux capteurs pour un diagnostic médical, tel qu'un ECG, lequel dispositif est agencé pour séparer au moins deux signaux ($S_1$, $S_2$) de chacun d'un certain nombre de mélanges de signaux, dans chaque dispositif, le nombre de mélanges ($X_1$, $X_2$) est au moins aussi grand que le nombre de signaux devant être séparés, le dispositif étant agencé de façon à comporter un critère modifié (V') basé sur un critère (V), qui est minimisé pour les paramètres de filtre estimés dans une structure de séparation, et une modification de régularisation (($\theta-\theta^{\#}$)C $(\theta-\theta^{\#})^H$,
   **caractérisé en ce que**
   la modification de régularisation est agencée de façon à comporter un premier vecteur ($\theta$) avec les paramètres de filtre devant être estimés, un second vecteur ($\theta^{\#}$) avec une information de paramètres de filtre basée sur une modélisation physique et une matrice (C) de pondération de paramètres de filtre, et un produit d'une différence entre lesdits premier ($\theta$) et second ($\theta^{\#}$) vecteurs, la matrice (C) de pondération de paramètres de filtre et une différence conjuguée est transposée ($C(\theta-\theta^{\#})^H$) entre lesdits premier et second vecteurs.

6. Dans un dispositif pour un traitement d'images destiné à fournir des images plus nettes de structures souhaitées, lequel dispositif est agencé pour séparer au moins deux signaux ($S_1$, $S_2$) de chacun d'un certain nombre de mélanges de signaux, où le nombre de mélanges ($X_1$, $X_2$) est au moins aussi grand que le nombre de signaux devant être séparés, le dispositif étant agencé de façon à comporter un critère modifié (V') basé sur un critère (V), qui est minimisé pour les paramètres de filtre estimés dans une structure de séparation, et une modification de régularisation (($\theta-\theta^{\#}$)$C(\theta-\theta^{\#})^H$,
   **caractérisé en ce que**
   la modification de régularisation est agencée de façon à comporter un premier vecteur ($\theta$) avec les paramètres de filtre devant être estimés, un second vecteur ($\theta^{\#}$) avec une information de paramètres de filtre basée sur une modélisation physique et une matrice (C) de pondération de paramètres de filtre, et un produit d'une différence entre lesdits premier ($\theta$) et second ($\theta^{\#}$) vecteurs, la matrice (C) de pondération de paramètres de filtre et une différence conjuguée est transposée ($C(\theta-\theta^{\#})^H$) entre lesdits premier et second vecteurs.

FIG.1

FIG.2

Bias of C

FIG.3a

Bias of D

FIG.3b

Standard deviation of C

FIG.3c

Standard deviation of D

FIG.3d

11

Mean Square Error of C

FIG.3e

Mean Square Error of D

FIG.3f

SNR of mixed signals (dotted) and seperated signals (solid)

FIG.4